# EUROPEAN PATENT APPLICATION

(11) **EP 3 327 839 A1**
(43) Date of publication of application: **30.05.2018**
(21) Application number: 16830237.0
(22) Date of filing: 04.07.2016
(51) Int. Cl.: H01M 4/86, H01M 8/18

(54) **REDOX FLOW BATTERY ELECTRODE, REDOX FLOW BATTERY, AND METHOD FOR EVALUATING ELECTRODE PROPERTIES**

(30) Priority: 24.07.2015 JP 2015146558
(71) Applicant: Sumitomo Electric Industries, Ltd., Osaka-shi, Osaka 541-0041 (JP)
(72) Inventor: ITO, Kenichi, Osaka-shi Osaka 554-0024 (JP)
(74) Representative: Boult Wade Tennant
(86) International application number: PCT/JP2016/069784
(87) International publication number: WO 2017/018132

(57) **Abstract**

An electrode for a redox flow battery, which is used in a redox flow battery that carries out a battery reaction using an electrolyte containing an active material, has a capacitance of more than 0.01 F/g. The electrode for a redox flow battery preferably has a charge transfer resistivity of 1 Ω·cm² or less. The electrode for a redox flow battery preferably has a density of 0.05 to 1.5 g/cm³.

## Description

### Technical Field

The present invention relates to an electrode for a redox flow battery, a redox flow battery, and an electrode characteristics evaluation method.

The present application is based upon and claims the benefit of priority from Japanese Patent Application No. 2015-146558, filed July 24, 2015, the entire contents of which are incorporated herein by reference.

### Background Art

A redox flow battery (hereinafter, may be referred to as an "RF battery") typically includes, as a main component, a battery cell including a positive electrode to which a positive electrode electrolyte is supplied, a negative electrode to which a negative electrode electrolyte is supplied, and a separation membrane disposed between the two electrodes. A porous body having open pores such as carbon felt (PTL 1) is used as each of the positive electrode and the negative electrode.

Furthermore, as an existing method for measuring the specific surface area of an electrode, a gas adsorption method such as a BET method is widely used (analogous art is disclosed in paragraph [0036] of PTL 1).

### Citation List

### Patent Literature

PTL 1: Japanese Unexamined Patent Application Publication No. 2013-065530

### Summary of Invention

An electrode characteristics evaluation method according to an embodiment of the present invention, which evaluates characteristics of an electrode used in a storage battery provided with an electrolyte that contains an active material, includes a step of immersing an electrode serving as a sample in an ionic solution that does not contain an active material and measuring the capacitance of the sample.

An electrode for a redox flow battery according to an embodiment of the present invention, which is used in a redox flow battery that carries out a battery reaction using an electrolyte containing an active material, has a capacitance of more than 0.01 F/g.

A redox flow battery according to an embodiment of the present invention includes an electrode for a redox flow battery according to the embodiment of the present invention. Brief Description of Drawings

[Fig. 1] Figure 1 is a graph showing the relationship between the capacitance and the charge transfer resistivity measured in Test Example 1.
[Fig. 2] Figure 2 is a graph showing the relationship between the capacitance and the charge transfer resistivity measured in Test Example 1 and showing selected samples.
[Fig. 3] Figure 3 is an explanatory diagram showing a basic configuration of a redox flow battery system including a redox flow battery according to Embodiment 1 and a basic operating principle.
[Fig. 4] Figure 4 is a schematic diagram showing an example of a cell stack provided in a redox flow battery according to Embodiment 1.

### Description of Embodiments

One of storage batteries is an RF battery in which a battery reaction is conducted by supplying electrolytes to electrodes. The RF battery has characteristics such as (1) ease of capacity increase to a megawatt (MW) level, (2) a long life, (3) capability of accurately monitoring the state of charge (SOC) of the battery, and (4) high design freedom such that battery output and battery capacity can be independently designed, and is expected to be a suitable storage battery for stabilization of electric power systems.

Examples of required characteristics for storage batteries such as RF batteries include a low internal resistance and excellent battery reactivity. For example, by using an electrode having a large specific surface area, such required characteristics can be satisfied.

### [Problems to be solved by the present disclosure]

A measurement test using a gas adsorption method such as a BET method is a destructive test. Therefore, it is desired to be able to evaluate electrode characteristics in a non-destructive manner and more easily.

Furthermore, regarding the gas adsorption method, it has been found that when an electrode that has been immersed in an ionic solution such as an electrolyte is used as a measurement sample, the specific surface area cannot be measured with high accuracy. One of the reasons for this is believed to be adhesion of ions to the electrode. Therefore, it is desired to be able to perform characteristics evaluation with high accuracy even on an electrode that has been immersed in an ionic solution, such as an electrode used in a storage battery provided with an electrolyte.

When characteristics of an electrode can be evaluated easily and with high accuracy, it is possible to easily determine whether battery characteristics of a storage battery such as an RF battery are good or bad on the basis of the evaluation, and it is possible to provide an RF battery having excellent battery reactivity.

Under these circumstances, it is an object of the disclosure to provide an electrode characteristics evaluation method which can evaluate characteristics of an electrode used in a storage battery easily and with high accuracy.

Furthermore, it is another object of the disclosure to provide a redox flow battery having a low internal resistance and excellent battery reactivity and an electrode for a redox flow battery that can be used to construct a redox flow battery having a low internal resistance and excellent battery reactivity.

### [Advantageous effects of the present disclosure]

In the electrode characteristics evaluation method according to the present disclosure, it is possible to evaluate characteristics of an electrode used in a storage battery easily and with high accuracy.

By using the electrode for a redox flow battery according to the present disclosure, it is possible to construct a redox flow battery having a low internal resistance and excellent battery reactivity. The redox flow battery according to the present disclosure has a low internal resistance and excellent battery reactivity.

### [Description of embodiments of the present invention]

Regarding an electrode formed of a porous body used in a storage battery provided with an electrolyte, the present inventors have studied a method for evaluating characteristics of the electrode easily and for evaluating characteristics of the electrode with high accuracy even after the electrode has been immersed in an ionic solution such as an electrolyte. Since the specific surface area cannot be measured easily and sometimes cannot be measured with high accuracy, performance parameters other than the specific surface area have been studied. The present inventors have paid attention to capacitance that can be measured, by various methods, easily and with high accuracy.

As a result, the present inventors found that there is a correlation in that as the capacitance increases, the charge transfer resistivity decreases.

In the case where an electrode having a low charge transfer resistivity is used in a storage battery provided with an electrolyte, internal resistance decreases, and a storage battery that easily carries out a battery reaction can be constructed. Accordingly, the magnitude of capacitance can be used to determine whether the characteristics of an electrode used in a storage battery are good or bad. Furthermore, as a performance parameter of an electrode used in a storage battery, capacitance is a new parameter, to which attention has not been paid. The present invention is based on these findings. First, contents of embodiments of the present invention are enumerated and described.

(1) An electrode characteristics evaluation method according to an embodiment of the present invention, which evaluates characteristics of an electrode used in a storage battery provided with an electrolyte that contains an active material, includes a step of immersing an electrode serving as a sample in an ionic solution that does not contain an active material and measuring the capacitance of the sample.
   In the electrode characteristics evaluation method, although an electrode used in a storage battery is used as a sample, the capacitance which is a performance parameter of the electrode can be measured in a non-destructive manner. Moreover, the capacitance can be measured with high accuracy, unlike with a gas adsorption method such as a BET method. On the basis of the magnitude of capacitance measured, it is possible to easily determine whether characteristics of the electrode are good or bad. As the capacitance increases, the charge transfer resistivity decreases (the details of which will be described later), and therefore, it is possible to determine whether or not the product is good. Accordingly, in the electrode characteristics evaluation method, it is possible to measure the characteristic parameter of an electrode easily and with high accuracy, and it is also possible to easily determine whether the electrode is good or bad.
(2) An electrode for a redox flow battery (RF battery) according to an embodiment of the present invention, which is used in a RF battery that carries out a battery reaction using an electrolyte containing an active material, has a capacitance of more than 0.01 F/g.
   Since the electrode for an RF battery has a large capacitance, by using the electrode, it is possible to construct an RF battery having a low internal resistance and excellent battery reactivity.
(3) For example, the electrode for an RF battery according to the embodiment may have a charge transfer resistivity of 1 Ω·cm² or less.
   Since the charge transfer resistivity of the electrode for an RF battery is low, by using the electrode, it is possible to construct an RF battery having a low internal resistance and excellent battery reactivity.
(4) For example, the electrode for an RF battery according to the embodiment may have a density of 0.05 to 1.5 g/cm³.
   By using the electrode for an RF battery, it is possible to construct an RF battery having a low internal resistance and excellent battery reactivity, and since the density of the electrode for an RF battery meets a specific range, it is possible to suppress an increase in pressure loss of the electrolyte due to an excessively high density of the electrode and suppress damage to a separation membrane due to fibers or the like constituting the electrode. Furthermore, in the RF battery, it is possible to suppress an increase in electrical resistance due to an excessively low density of the electrode.
(5) For example, the electrode for an RF battery according to the embodiment may have a mass per unit area of 50 to 300 g/m².
   The mass per unit area of the electrode affects the density of the electrode. By using the electrode for an RF battery according to the embodiment, it is possible to construct an RF battery having a low internal resistance and excellent battery reactivity, and since the RF battery includes the electrode for an RF battery whose mass per unit area meets a specific range, the density is likely to be in an appropriate range, and it is possible to reduce the problems due to the excessively high or excessively low density described in (4).
(6) A redox flow battery (RF battery) according to an embodiment of the present invention includes the electrode for an RF battery according to any one of (2) to (5).
   The RF battery includes the electrode for an RF battery having a large capacitance, and therefore has a low internal resistance and excellent battery reactivity.
(7) For example, the RF battery according to the embodiment may include a frame assembly including a bipolar plate on which the electrode for a redox flow battery is disposed and a frame which is formed on the outer periphery of the bipolar plate, the frame having a difference in level of 0.2 to 1.0 mm. The difference in level of the frame refers to a difference in level provided between the front surface (or back surface) of the frame and the front surface (or back surface) of the bipolar plate. In the RF battery, the electrode is disposed in such a stepped portion.

In the embodiment described above, the internal resistance is low, the battery reactivity is excellent, and the difference in level of the frame is in a specific range. Therefore, the thickness of the electrode to be disposed in the stepped portion can be controlled to the range of the difference in level. Consequently, in the embodiment, since the thickness of the electrode is small to a certain degree, the electrolyte can satisfactorily diffuse throughout the electrode, and it is possible to suppress an increase in electrical resistance; and since the thickness of the electrode is large to a certain degree, the reaction area of the electrode can be easily secured, and the thickness of the electrode can be easily controlled by the thickness of the frame.

### [Detailed description of embodiments of the present invention]

The redox flow battery (RF battery) according to the embodiment of the present invention, the electrode for an RF battery, and the electrode characteristics evaluation method according to the embodiment of the present invention will be described in detail with reference to the drawings, appropriately. In the drawings, the same reference signs denote the same components.

### [Embodiment 1]

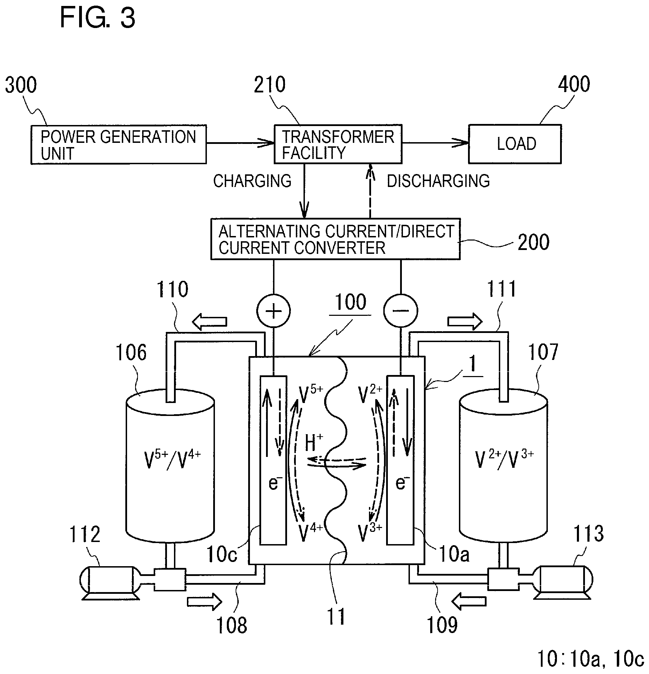

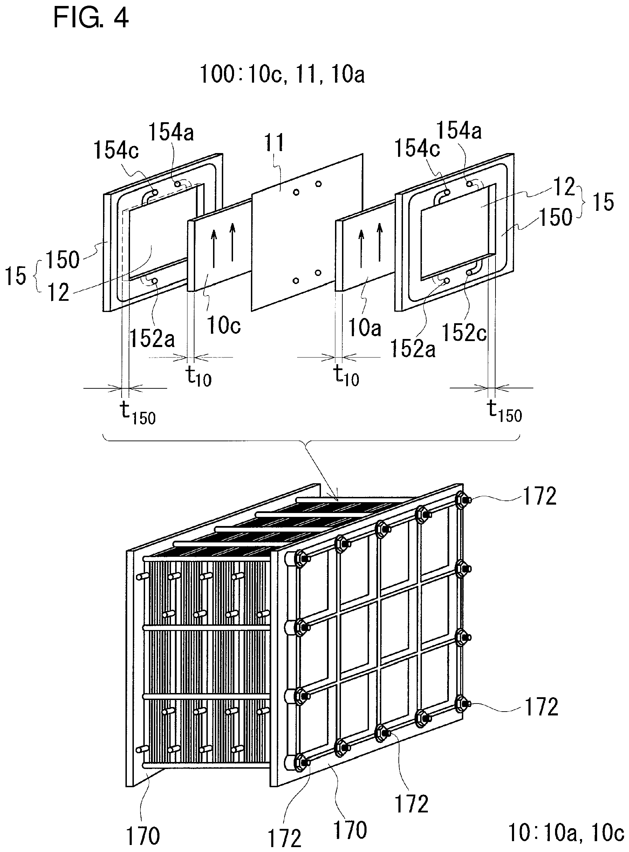

A basic configuration of an RF battery system provided with an RF battery 1 according to Embodiment 1 will be described with reference to Figs. 3 and 4, and then, an electrode for an RF battery 10 (hereinafter, may be referred to as an "electrode 10") provided in the RF battery 1 will be described in more detail. In Fig. 3, ions shown inside a positive electrode tank 106 and a negative electrode tank 107 are examples of ion species contained in the electrolytes of the electrodes. In Fig. 3, solid line arrows indicate charging, and dashed line arrows indicate discharging.

### (Overview of RF battery)

When the RF battery 1 according to Embodiment 1 is used, an RF battery system including a circulation mechanism for circulating and supplying electrolytes to the RF battery 1, such as the one shown in Fig. 3, is constructed. The RF battery 1 is typically connected, through an alternating current/direct current converter 200, a transformer facility 210, and the like, to a power generation unit 300 and a load 400 such as an electric power system or consumer. The RF battery 1 performs charging by using the power generation unit 300 as an electric power supply source, and performs discharging to the load 400 as an electric power supply target. Examples of the power generation unit 300 include solar power generation apparatuses, wind power generation apparatuses, and other general power plants.

### (Basic configuration of RF battery)

The RF battery 1 includes, as a main component, a battery cell 100 including a positive electrode 10c to which a positive electrode electrolyte is supplied, a negative electrode 10a to which a negative electrode electrolyte is supplied, and a separation membrane 11 interposed between the positive electrode 10c and the negative electrode 10a. Typically, the RF battery 1 includes a plurality of battery cells 100, and a bipolar plate 12 is provided between the adjacent battery cells 100 (Fig. 4).

An electrolyte that contains an active material is supplied to the electrode for an RF battery 10. The electrode for an RF battery 10 is a reaction site where the active material (ions) in the electrolyte causes a battery reaction, and is formed of a porous body so that the electrolyte can be circulated. One of the features of the electrode for an RF battery 10 according to Embodiment 1 is that the capacitance of the electrode meets a specific range as will be described later. One of the features of the RF battery 1 according to Embodiment 1 is that the RF battery 1 includes an electrode 10 whose capacitance is in a specific range.

The separation membrane 11 is a separating member that separates the positive electrode 10c and the negative electrode 10a from each other and is also a member through which predetermined ions permeate.

The bipolar plate 12 is a planar member sandwiched between the positive electrode 10c and the negative electrode 10a and is a conductive member that conducts an electric current but does not permit an electrolyte to flow therethrough.

As shown in Fig. 4, the bipolar plate 12 is typically used in the form of a frame assembly 15 including a frame 150 formed on the outer periphery of the bipolar plate 12. The fame 150 includes liquid supply holes 152c and 152a and liquid drainage holes 154c and 154a opened to the front surface and back surface thereof, the liquid supply holes 152c and 152a being configured to supply electrolytes to electrodes 10 disposed on the bipolar plate 12, the liquid drainage holes 154c and 154a being configured to discharge electrolytes. An electrode 10 is disposed in a stepped portion provided between the front surface or back surface of the frame 150 and the front surface or back surface of the bipolar plate 12. More specifically, the electrode 10 is disposed in a recess in which the bipolar plate 12 serves as a bottom and the inner peripheral wall of the frame 150 serves as a wall surface. The difference in level t₁₅₀ of the frame 150 (thickness of the stepped portion) controls the thickness t₁₀ of the electrode 10 and therefore preferably meets a specific range which will be described later.

A plurality of battery cells 100 are stacked and used in the form of a cell stack. As shown in Fig. 4, the cell stack is formed by repeatedly stacking a bipolar plate 12 of a frame assembly 15, a positive electrode 10c, a separation membrane 11, a negative electrode 10a, a bipolar plate 12 of another frame assembly 15, and so on in this order. In the case where the RF battery 1 is designed for large capacity use or the like, a sub-cell stack including a predetermined number of battery cells 100 is prepared, and a plurality of sub-cell sacks are stacked for use. Figure 4 shows an example in which a plurality of sub-cell stacks are provided. Current collector plates (not shown), instead of bipolar plates 12, are disposed on electrodes 10 located at both ends in the stacking direction of battery cells 100 in a sub-cell stack or cell stack. End plates 170 are disposed on both ends in the stacking direction of battery cells 100 in a cell stack, and a pair of end plates 170 are joined with joining members 172, such as long bolts, and integrated.

### (Overview of RF battery system)

The RF battery system includes the RF battery 1 and a circulation mechanism described below. The circulation mechanism includes a positive electrode tank 106 which stores a positive electrode electrolyte to be circulated and supplied to the positive electrode 10c, a negative electrode tank 107 which stores a negative electrode electrolyte to be circulated and supplied to the negative electrode 10a, pipes 108 and 110 which connect the positive electrode tank 106 and the RF battery 1, pipes 109 and 111 which connect the negative electrode tank 107 and the RF battery 1, and pumps 112 and 113 provided on the upstream side (supply side) pipes 108 and 109, respectively. By stacking a plurality of frame assemblies 15, liquid supply holes 152c and 152a and liquid drainage holes 154c and 154a constitute electrolyte flow ducts, and the pipes 108 to 111 are connected to the ducts.

In the RF battery system, by using the positive electrode electrolyte circulation path including the positive electrode tank 106 and the pipes 108 and 110 and the negative electrode electrolyte circulation path including the negative electrode tank 107 and the pipes 109 and 111, the positive electrode electrolyte is circulated and supplied to the positive electrode 10c, and the negative electrode electrolyte is circulated and supplied to the negative electrode 10a. As a result of the circulation and supply, the RF battery 1 performs charging and discharging in response to valence change reactions of ions serving as active materials in the electrolytes of the electrodes.

### (Electrode)

### • Material and structure

The electrode 10 is formed of a porous body having a plurality of open pores. Examples of the porous body include porous carbon materials, such as carbon fiber aggregates composed mainly of carbon fibers, and carbon foam. Specific examples of carbon fiber aggregates include carbon felt, carbon paper, carbon cloth, and the like. The porous carbon materials can contain carbon black, carbon nanotubes, and the like, and when contained, it is possible to achieve expansion of surface area and the like. The carbon fiber size (fiber diameter) is, for example, about 1 to 10 µm.

The use of carbon felt provides advantages such as (a) being unlikely to generate oxygen gas even at an oxygen generation potential during charging in the case where an aqueous solution is used as an electrolyte, (b) a large surface area, and (c) excellent circulation of electrolyte.

The use of carbon paper provides advantages such as (α) ease of fabrication of a thin, small battery and (β) excellent electrical conductivity.

### • Physical properties

### •• Capacitance (performance parameter)

One of the features of the electrode 10 is a large capacitance. Specifically, the capacitance of the electrode 10 is more than 0.01 F/g. As the capacitance increases, the charge transfer resistivity decreases, and thus it is possible to obtain an RF battery 1 having a low internal resistance and excellent battery reactivity. Accordingly, the capacitance is preferably 0.05 F/g or more, and more preferably 0.06 F/g or more, 0.1 F/g or more, or 0.2 F/g or more.

However, when the capacitance increases excessively, the specific surface area of the electrode 10 may increase in some cases. An increase in specific surface area leads to an increase in porosity, which is likely to decrease bulk density. As a result, electrical conductivity is likely to decrease, which can lead to an increase in internal resistance. From this viewpoint, the capacitance is preferably 70 F/g or less.

The capacitance range described above is determined by focusing on the mass of the electrode 10, regardless of the two-dimensional shape, three-dimensional shape, size, and the like of the electrode 10.

On the other hand, when focusing on the area of the electrode 10, the capacitance of the electrode 10 is preferably more than 2 mF/cm², and more preferably 3 mF/cm² or more, 4 mF/cm² or more, or 5 mF/cm² or more. For example, when the mass per unit area of the electrode 10 is 300 g/m², a capacitance of 2 mF/cm² corresponds to about 0.06 F/g.

### Charge transfer resistivity

When the capacitance of the electrode 10 is large, the charge transfer resistivity is low. As the charge transfer resistivity decreases, it is possible to obtain an RF battery 1 having a lower internal resistance and excellent battery reactivity. Accordingly, the charge transfer resistivity of the electrode 10 is preferably 1 Ω·cm² or less, and more preferably 0.8 Ω·cm² or less, 0.7 Ω·cm² or less, or 0.6 Ω·cm² or less.

### •• Density

When the electrode 10 is dense to a certain degree, the reaction area is easily secured, and electrical resistance can be decreased. On the other hand, when the electrode 10 is coarse to a certain degree, the electrolyte can be easily made to flow through the electrode 10, pressure loss (pump loss) can be reduced, and it is possible to prevent the separation membrane 11 from being damaged by being pierced by fibers or the like constituting the electrode 10. When the density of the electrode 10 is 0.05 to 1.5 g/cm³, these effects can be expected. As the density increases, the reaction area increases, and electrical resistance can be decreased. Therefore, the density of the electrode 10 is preferably 0.1 g/cm³ or more, and more preferably 0.3 g/cm³ or more, or 0.35 g/cm³ or more. As the density decreases, pressure loss can be reduced, and damage on the separation membrane 11 can be reduced. Therefore, the density of the electrode 10 is preferably 1.0 g/cm³ or less, and more preferably 0.8 g/cm³ or less. In the case of an electrode 10 composed of an easily deformable material, when assembled into the RF battery 1 and sandwiched between the end plates 170, followed by being fastened in a predetermined manner, there is a possibility that the volume and thickness t₁₀ (which will be described later) of the electrode 10 may be changed. Accordingly, preferably, the density and thickness t₁₀ of the electrode 10 before being assembled into the RF battery 1 meet the specific range described above and the specific range described later, respectively.

### •• Thickness

It is preferable to adjust the thickness t₁₀ of the electrode 10 in accordance with the density of the electrode 10. For example, when the density is large to a certain degree (e.g., 0.1 g/cm³ or more), even if the thickness t₁₀ is small (even if thin), e.g., 0.5 mm or less, the reaction area is easily secured. When the density is small to a certain degree (e.g., less than 0.1 g/cm³), if the thickness t₁₀ is large (if thick) to a certain degree, e.g., more than 0.5 mm, the reaction area can be sufficiently secured. However, as described above, the thickness t₁₀ of the electrode 10 may be changed, and in the state in which the electrode 10 is assembled into the RF battery 1, the thickness t₁₀ is controlled by the difference in level t₁₅₀ of the frame 150. Accordingly, it is appropriate to adjust the density and thickness t₁₀ of the electrode 10 in consideration of the thickness t₁₅₀ of the frame 150 and the capacitance.

### •• Mass per unit area

When the mass per unit area of the electrode 10 is in a specific range, the density of the electrode 10 is likely to meet the appropriate range described above. Therefore, the mass per unit area of the electrode 10 is preferably 50 to 300 g/m². When the mass per unit area is 50 g/m² or more, the electrode 10 is moderately dense, and the reaction area is easily secured. The mass per unit area is more preferably 100 g/m² or more, 125 g/m² or more, or 150 g/m² or more. When the mass per unit area is 300 g/m² or less, the electrode 10 is moderately coarse, and the electrolyte is easily made to flow through the electrode 10. The mass per unit area is more preferably 250 g/m² or less, 225 g/m² or less, or 200 g/m² or less. Even when the mass per unit area is small, if the capacitance is large, it is possible to construct an RF battery 1 having a low internal resistance and excellent battery reactivity. In the case of an electrode 10 having a large mass per unit area but a small capacitance, the thickness t₁₀ is preferably large to a certain degree.

### • Production

The electrode 10 according to Embodiment 1 can be produced using a known production method. However, the fiber diameter, density, thickness t₁₀, mass per unit area, and the like are adjusted so that the capacitance meets the specific range described above.

### (Other constituent members of RF battery)

### • Frame assembly

### •• Bipolar plate

The bipolar plate 12 is made of a conductive material that has a low electrical resistance, that does not react with the electrolyte, and that has resistance to electrolyte (chemical resistance, acid resistance, and the like), and typically is made of a material containing a carbon material. For example, a composite material containing a carbon material and an organic material, more specifically, a conductive plastic containing a conductive inorganic material such as graphite (powder, fibers, or the like) and an organic material such as a polyolefin-based organic compound or chlorinated organic compound, which is formed into a plate, can be used.

### •• Frame

The frame 150 is made of a resin or the like that has excellent resistance to electrolyte and electrical insulation properties. The difference in level t₁₅₀ in the frame 150 controls the thickness t₁₀ of the electrode 10 to be disposed on the bipolar plate 12. Although depending on the capacitance, density, mass per unit area, and the like, the difference in level t₁₅₀ is preferably 0.2 to 1.0 mm. When the difference in level t₁₅₀ of the frame 150 is 0.2 mm or more, the reaction area of the electrode 10 can be easily secured, and the thickness t₁₀ of the electrode 10 can be easily controlled in accordance with the difference in level t₁₅₀ of the frame 150. Therefore, the difference in level t₁₅₀ is more preferably 0.3 mm or more, 0.4 mm or more, or 0.5 mm or more. When the difference in level t₁₅₀ of the frame 150 is 1.0 mm or less, the electrolyte can satisfactorily diffuse throughout the electrode 10, exhibiting excellent diffusibility of the electrolyte, and it is possible to easily suppress an increase in electrical resistance. Therefore, the difference in level t₁₅₀ is more preferably 0.9 mm or less, 0.8 mm or less, or 0.7 mm or less.

### • Separation membrane

As the separation membrane 11, for example, an ion exchange membrane, such as a cation exchange membrane or anion exchange membrane, may be used. The ion exchange membrane has characteristics such as (1) excellent separation between ions of the positive electrode active material and ions of the negative electrode active material, and (2) excellent permeability of H⁺ ions serving as a charge carrier in the battery cell 100, and can be suitably used for the separation membrane 11. As the separation membrane 11, a known separation membrane can be used.

### (Electrolyte)

The electrolyte used in the RF battery 1 contains active material ions, such as metal ions and non-metal ions. Examples of the electrolyte used in the RF battery 1 include a V-based electrolyte containing vanadium (V) ions having different valences (Fig. 3) as a positive electrode active material and a negative electrode active material. Examples of other electrolytes include an Fe-Cr electrolyte containing iron (Fe) ions as a positive electrode active material and chromium (Cr) ions as a negative electrode active material and a Mn-Ti electrolyte containing manganese (Mn) ions as a positive electrode active material and titanium (Ti) ions as a negative electrode active material. As the electrolyte, an aqueous solution containing, in addition to the active material, at least one acid or acid salt selected from the group consisting of sulfuric acid, phosphoric acid, nitric acid, hydrochloric acid, and salts thereof can be used.

### (Advantages)

The RF battery 1 according to Embodiment 1 includes the electrode 10 having a large capacitance according to Embodiment 1, and therefore has a low internal resistance and excellent battery reactivity. For example, the internal resistance of the RF battery 1 can be set to be 2 Ω·cm² or less, 1.5 Ω·cm² or less, or 1.3 Ω·cm² or less. This advantage will be specifically described in Test Example below.

### (Electrode characteristics evaluation method)

An electrode characteristics evaluation method according to Embodiment 1 will now be described.

The electrode characteristics evaluation method according to Embodiment 1 is used to evaluate characteristics of an electrode 10 used in a storage battery provided with an electrolyte that contains an active material, such as the RF battery 1 according to Embodiment 1. In particular, the electrode characteristics evaluation method according to Embodiment 1 uses capacitance as a performance parameter for determining whether characteristics of the electrode is good or bad.

The electrode characteristics evaluation method according to Embodiment 1 includes a step of immersing an electrode serving as a sample in an ionic solution and measuring the capacitance of the sample. On the basis of the measured capacitance, it is determined whether the electrode serving as the sample is good or bad.

### • Ionic solution

The ionic solution used in the measurement does not contain an active material. That is, the ionic solution used in the measurement does not contains ions that participate in a battery reaction, such as active material ions, but contains ions that do not substantially participate in a battery reaction. In particular, when an ionic aqueous solution is used, preparation can be easily performed. Examples of ionic solutions containing various acids or acid salts include aqueous solutions (including dilute acids) containing various acid ions, such as sulfate ions, nitrate ions, and phosphate ions. Examples of ionic solutions containing a neutral salt such as NaCl include aqueous solutions containing element ions, such as Na ions and Cl ions.

In the RF battery 1, as described above, a sulfuric acid solution or the like containing an active material is used as an electrolyte. Accordingly, as the ionic solution, an ionic solution containing ions common to those in the electrolyte provided in the storage battery can be used. For example, in the case where the electrolyte is a sulfuric acid solution, a sulfuric acid solution can be used as the ionic solution. When an ionic solution containing common ions is used, it is believed that mass transport behavior of ions during battery reaction closely resembles mass transport behavior of ions during measurement to enhance correlation between capacitance and charge transfer resistivity.

### • Sample

In the electrode characteristics evaluation method according to Embodiment 1, a non-destructive test, unlike a BET method which is a destructive test, is carried out. Accordingly, it is possible to use, as a sample, not only an electrode before being assembled into a storage battery, but also an electrode detached from a storage battery that has been charged and discharged or an electrode in a state of being assembled into a storage battery. The electrode detached from the storage battery that has been charged and discharged may have active material ions adhering thereto because of having been immersed in the electrolyte, and therefore is preferably cleaned with a cleaning liquid. As the cleaning liquid, water such as pure water, an ionic solution used in measurement, or the like can be used. The electrode in a state of being assembled into the storage battery may also have active material ions adhering thereto because of being immersed in the electrolyte. For example, a method may be used in which the electrolyte inside the tank 106 or 107 is replaced with a cleaning liquid, the electrode is cleaned by circulating and supplying the cleaning liquid, and then the cleaning liquid that can contain the active material is replaced with a clean ionic solution.

### • Measuring apparatus

In order to measure the capacitance, for example, cyclic voltammetry, an AC impedance method, a charge and discharge test, or the like can be used. A known measuring apparatus can be used to measure the capacitance. When a charge and discharge test is used, for example, by performing charging and discharging at constant current, a correlation between time and the voltage between the positive electrode and the negative electrode (time-voltage curve) is obtained, and the capacitance can be determined from the curve.

### • Evaluation method

On the basis of the magnitude of capacitance measured, it is determined whether characteristics of the electrode serving as a sample are good or bad. An electrode having a large capacitance has a low charge transfer resistivity as described above, and when assembled into a storage battery such as an RF battery 1, it is possible to construct a storage battery having a low internal resistance and excellent battery reactivity. Accordingly, when the measured capacitance is more than a predetermined threshold value (predetermined capacitance), the sample is evaluated as an electrode having excellent characteristics (good article). The threshold value can be set to be, for example, 0.01 F/g. In such a case, it is possible to determine whether the electrode is good or bad depending on whether the measured capacitance is more than 0.01 F/g, or 0.01 F/g or less. When the measured capacitance is equal to or more than a predetermined threshold value, the sample may be evaluated as an electrode having excellent characteristics (good article). The threshold value may be set to be 0.06 F/g, 2 mF/cm², etc.

It is possible to design an apparatus (configuration) which automatically determines whether the electrode is good or bad by combining a determination device which determines whether the electrode is good or bad and a measuring apparatus which measures the capacitance of the electrode. The determination device is connected to the measuring apparatus or built in the measuring apparatus. The determination device, for example, includes an input unit to which measured data is input, a storage unit which stores the threshold value and the like, and a determination unit which compares the threshold value called up from the storage unit and the input data and determines whether the electrode is good or bad. As the determination device, a computer or the like can be used.

### • Application

The electrode characteristics evaluation method according to Embodiment 1 can be applied, for example, to the following cases:
(1) At the time of design and development of a storage battery such as an RF battery, characteristics of an electrode before being assembled are confirmed.
(2) At the time of design and development of a storage battery such as an RF battery, when a problem, such as degradation in characteristics, has occurred in a charge and discharge test, it is determined whether or not the problem is due to a problem of an electrode.
(3) It is determined whether or not maintenance of a storage battery such as an RF battery is required. For example, by periodically measuring the capacitance of an electrode of a storage battery such as an RF battery, variations in the capacitance are confirmed. During operation of a storage battery, there is a possibility that the capacitance may decrease over time because of adhesion of ions, precipitates, or the like to an electrode, damage such as a break occurring in an electrode, or the like. Since the decrease in capacitance can be considered degradation of the electrode, it is possible to use the electrode characteristics evaluation method to determine whether or not maintenance, such as replacement or cleaning of the electrode, is required.

### (Advantages of characteristics evaluation method)

Since the electrode characteristics evaluation method according to Embodiment 1 is a non-destructive test, electrode characteristics evaluation can be performed easily. Furthermore, in the electrode characteristics evaluation method according to Embodiment 1, since an ionic solution is used to measure a performance parameter (capacitance in this example), even when an electrode to which ions have adhered is used as a sample, it is possible to measure the performance parameter with high accuracy. Furthermore, when the electrode characteristics evaluation method according to Embodiment 1 is used, it is possible to easily determine whether characteristics of the electrode are good or bad. Therefore, the characteristics evaluation method is expected to contribute to constructing a storage battery such as an RF battery having a low internal resistance and excellent battery reactivity.

### [Test Example 1]

Electrodes formed of various porous bodies were prepared, and capacitance and charge transfer resistance were examined.

In this test, carbon felt and carbon paper were prepared as electrodes as described below.

In each of Sample Nos. 1-1 to 1-7 in which carbon felt was used, the density was 0.1 to 1.5 g/cm³, the mass per unit area was 70 to 300 g/m², and the thickness (thickness before being assembled into an RF battery described later) was 0.3 to 1.5 mm.

In each of Sample Nos. 2-1 to 2-3 in which carbon paper was used, the density was 0.2 to 0.5 g/cm³, the mass per unit area was 70 to 200 g/m², and the thickness (thickness before being assembled into an RF battery described later) was 0.2 to 0.5 mm.

In this test, using the electrode of each sample, an RF battery provided with a single battery cell was constructed. The difference in level of the frame in the frame assembly was 0.4 mm in each of Sample Nos. 1-1 to 1-7 in which carbon felt was used, and 0.3 mm in each of Sample Nos. 2-1 to 2-3 in which carbon paper was used.

As an ionic solution, a 6 M (6 mol concentration) sulfuric acid solution was prepared. The ionic solution was supplied to the battery cell of the resulting RF battery, and while maintaining a state in which the electrode was immersed in the ionic solution (6 M sulfuric acid), the capacitance (mF/cm²) of the electrode was measured by cyclic voltammetry. The capacitance was measured by using a commercially available measuring apparatus in a two-electrode system. The voltage sweeping range was -0.2 to 0.2 V, and the sweeping rate was 10 mV/sec. The measurement results (mF/cm²) are shown in Table 1. The corresponding values in terms of F/g are also shown in Table 1. Furthermore, in this test, the charge transfer resistivity of Sample No. 1-1 was considered as a reference value, and the relative value of the charge transfer resistivity of each sample to the reference value (charge transfer resistivity of each sample/reference value) is also shown in Table 1.

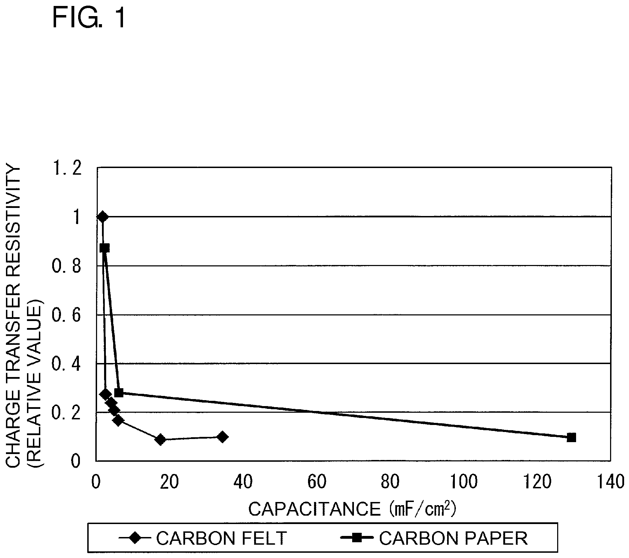

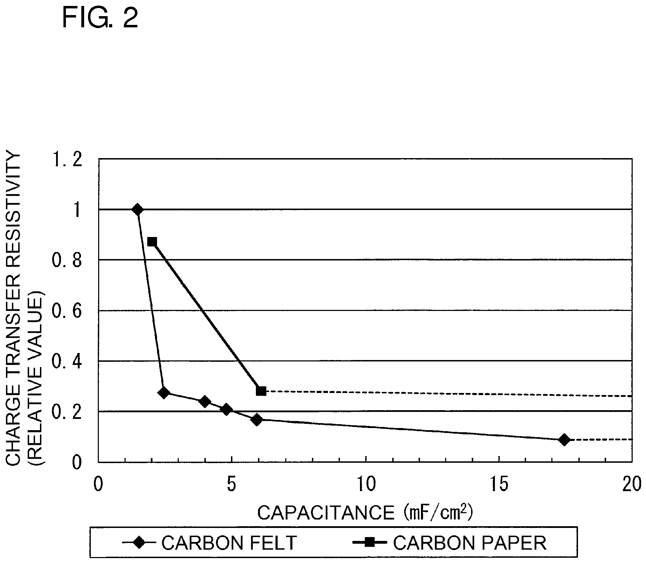

After the capacitance was measured, a V-based electrolyte, instead of the ionic solution, was supplied to the battery cell of the RF battery, and the charge transfer resistivity (Ω·cm²) was measured by an AC impedance method. The charge transfer resistivity was measured by using a commercially available measuring apparatus at an open-circuit voltage. The voltage amplitude was 10 mV, and the measuring frequency range was 10 kHz to 10 mHz. The measurement results are shown in Table 1 and Figs. 1 and 2. Figure 2 shows selected results of Sample Nos. 1-1 to 1-6, 2-1, and 2-2. In the graphs of Figs. 1 and 2, the horizontal axis indicates the capacitance (mF/cm²) and the vertical axis indicates the charge transfer resistivity (relative value).

In this test, using the same electrode, measurement of capacitance and measurement of charge transfer resistivity were performed in this order. However, the measurement order may be reversed. When the measurement order is reversed, as described above, it is appropriate to measure the capacitance after the electrode impregnated with a V-based electrolyte has been cleaned. Alternatively, by preparing an electrode for measuring capacitance and an electrode for measuring charge transfer resistivity, measurement may be performed separately.

The internal resistance of each of the fabricated RF batteries provided with a single battery cell was measured. The results thereof are shown in Table 1. In this test, the V-based electrolyte used in the measurement of charge transfer resistivity was supplied to the battery cell, a current with a constant current density (70 A/cm2) was applied, and an internal resistance was obtained by using the cell voltage after a predetermined period of time and the current value at that time.

**[Table 1]**

| Sample No. | Capacitance | | Charge transfer resistivity | | Internal resistance |
|---|---|---|---|---|---|
| | F/g | mF/cm² | Ω·cm² | Relative value | Ω·cm² |
| 1-1 | 0.16 | 1.5 | 2.47 | (Reference) 1.00 | 3.12 |
| 1-2 | 0.29 | 2.5 | 0.68 | 0.27 | 1.23 |
| 1-3 | 0.23 | 4.0 | 0.59 | 0.24 | 1.16 |
| 1-4 | 0.19 | 4.8 | 0.52 | 0.21 | 1.12 |
| 1-5 | 0.30 | 5.9 | 0.41 | 0.17 | 0.99 |
| 1-6 | 1.1 | 17.5 | 0.22 | 0.09 | 0.85 |
| 1-7 | 1.4 | 34.4 | 0.24 | 0.10 | 0.90 |
| 2-1 | 0.24 | 2.0 | 2.15 | 0.87 | 3.81 |
| 2-2 | 0.64 | 6.1 | 0.69 | 0.28 | 1.90 |
| 2-3 | 11 | 129.3 | 0.24 | 0.10 | 0.92 |

As shown in Table 1, in each of Sample Nos. 1-1 and 2-1, the charge transfer resistivity is 2.5 Ω·cm² or less, but is more than 2 Ω·cm². In each of Sample Nos. 1-2 to 1-7, 2-2, and 2-3, the charge transfer resistivity is 1 Ω·cm² or less, which is lower. In particular, in each of Sample Nos. 1-5 to 1-7 and 2-3, the charge transfer resistivity is less than 0.5 Ω·cm², which is further lower.

As shown in Table 1 and Figs. 1 and 2, as the capacitance of the electrode increases, the charge transfer resistivity tends to decrease. As shown in detail in Fig. 2, when the capacitance exceeds 2 mF/cm², the charge transfer resistivity decreases greatly.

In Sample Nos. 1-2 to 1-7 in which carbon felt is used, the capacitance is more than 2 mF/cm² and further 2.5 mF/cm² or more. The charge transfer resistivity of Sample Nos. 1-2 to 1-4 whose capacitance is 2.5 mF/cm² or more is about 1/4 or less of the charge transfer resistivity of Sample No. 1-1. The charge transfer resistivity of Sample No. 1-5 whose capacitance is 5 mF/cm² or more is about 1/5 or less of the charge transfer resistivity of Sample No. 1-1. Furthermore, the charge transfer resistivity of Sample Nos. 1-6 and 1-7 whose capacitance is 15 mF/cm² or more is about 1/10 or less of the charge transfer resistivity of Sample No. 1-1. Consequently, it is obvious that in Sample Nos. 1-2 to 1-7, the charge transfer resistivity is further lower.

From the results of Sample Nos. 1-2 to 1-7, it is obvious that, at 0.25 F/g or more, 0.3 F/g or more, or 1.0 F/g or more, the charge transfer resistivity further decreases.

In Sample Nos. 2-2 and 2-3 in which carbon paper is used, the capacitance is more than 2 mF/cm² and further 5 mF/cm² or more. The charge transfer resistivity of No. 2-2 whose capacitance is 5 mF/cm² or more is about 1/4 or less of the charge transfer resistivity of Sample No. 1-1. Furthermore, the charge transfer resistivity of No. 2-2 whose capacitance is 100 mF/cm² or more is about 1/10 or less of the charge transfer resistivity of Sample No. 1-1. It is obvious that in Sample Nos. 2-2 and 2-3, the charge transfer resistivity is further lower.

From the results of Sample Nos. 2-2 and 2-3, it is obvious that, at 0.25 F/g or more, 0.5 F/g or more, or 10 F/g or more, the charge transfer resistivity further decreases.

Furthermore, in this test, the results of Sample Nos. 1-6, 1-7, and 2-3 show that when the capacitance increases to a certain degree, the charge transfer resistivity tends to converge to a constant value. As the capacitance increases, the charge transfer resistivity can decrease. However, it is believed that, when the capacitance is a certain value or more, for example, 17 mF/cm² or more, or 40 mF/cm² or more, the charge transfer resistivity decreases sufficiently and converges to an almost constant value. Furthermore, it is believed that, when the capacitance is, for example, 1.1 F/g or more, or 1.5 F/g or more, the charge transfer resistivity decreases sufficiently and converges to an almost constant value.

As shown in Table 1, each of the RF batteries using the electrodes of Sample Nos. 1-2 to 1-7, 2-2, and 2-3 having a larger capacitance and a lower charge transfer resistivity has a lower internal resistance of 2 Ω·cm² or less, or 1.5 Ω·cm² or less. There is a sample whose internal resistance is 1.0 Ω·cm² or less. Thus, each of the RF batteries using the electrodes of Sample Nos. 1-2 to 1-7, 2-2, and 2-3 and having a lower internal resistance has excellent battery reactivity.

In this test, the internal resistance of each of the RF batteries using the electrodes of Sample Nos. 1-1 and 2-1 is 4 Ω·cm² or less, but is more than 3 Ω·cm².

Furthermore, the test results show that the capacitance can change depending on the mass per unit area, density, material, and the like of the electrode. Consequently, when an electrode has a capacitance of more than 0.01 F/g, preferably 0.06 F/g or more, or 0.1 F/g or more, the charge transfer resistivity is low, and it is expected to be possible to construct a storage battery having a low internal resistance and excellent battery reactivity.

In order to examine reasons why such results were obtained, various electrodes (carbon felt in this test) were prepared, and the specific surface area was checked by using a BET method. For each sample, an electrode for measuring capacitance and an electrode for measuring specific surface area were prepared. The capacitance was measured by cyclic voltammetry, using 6 M sulfuric acid as in the above description. The specific surface area was measured by using a commercially available specific surface area measuring apparatus using nitrogen gas adsorption. As a result, it was found that in the case of electrodes having a large capacitance, some electrodes had a large specific surface area. For example, in electrodes having a capacitance of about 10 F/g, some electrodes had a specific surface area of about 200 m²/g. Accordingly, one of the reasons why it was possible to construct a storage battery such as an RF battery having a low internal resistance and excellent battery reactivity by using an electrode having a large capacitance is believed to be that the electrode has a large specific surface area.

It is shown from the above results that capacitance can be used to determine whether battery characteristics are good or bad. It is also shown that by using an electrode having a large capacitance, it is possible to construct a storage battery such as an RF battery having a low internal resistance and excellent battery reactivity.

The present invention is not limited to the examples shown above, but is defined by appended claims, and is intended to include all modifications within the meaning and scope equivalent to those of the claims. For example, although a V-based electrolyte is used in Test Example 1, a Ti-Mn electrolyte, an Fe-Cr electrolyte, or other electrolytes may be used. Furthermore, although carbon felt and carbon paper are used as electrodes in Test Example 1, carbon cloth, carbon foam, or the like may be used.

### Reference Signs List

- 1: redox flow battery (RF battery)
- 10: electrode for redox flow battery (RF battery)
- 10c: positive electrode
- 10a: negative electrode
- 11: separation membrane
- 12: bipolar plate
- 100: battery cell
- 15: frame assembly
- 150: frame
- 152c, 152a: liquid supply hole
- 154c, 154a: liquid drainage hole
- 170: end plate
- 172: joining member
- 106: positive electrode tank
- 107: negative electrode tank
- 108 to 111: pipe
- 112, 113: pump
- 200: alternating current/direct current converter
- 210: transformer facility
- 300: power generation unit
- 400: load

## Claims

1. An electrode characteristics evaluation method which evaluates characteristics of an electrode used in a storage battery provided with an electrolyte that contains an active material, the method comprising:
a step of immersing an electrode serving as a sample in an ionic solution that does not contain an active material and measuring the capacitance of the sample.

2. An electrode for a redox flow battery, which is used in a redox flow battery that carries out a battery reaction using an electrolyte containing an active material, wherein the electrode has a capacitance of more than 0.01 F/g.

3. The electrode for a redox flow battery according to Claim 2, wherein the electrode has a charge transfer resistivity of 1 Ω·cm² or less.

4. The electrode for a redox flow battery according to Claim 2 or 3, wherein the electrode has a density of 0.05 to 1.5 g/cm³.

5. The electrode for a redox flow battery according to any one of Claims 2 to 4, wherein the electrode has a mass per unit area of 50 to 300 g/m².

6. A redox flow battery comprising the electrode for a redox flow battery according to any one of Claims 2 to 5.

7. The redox flow battery according to Claim 6, further comprising a frame assembly including a bipolar plate on which the electrode for a redox flow battery is disposed and a frame which is formed on the outer periphery of the bipolar plate,
wherein the frame has a difference in level of 0.2 to 1.0 mm.
